Europäisches Patentamt

European Patent Office

Office européen des brevets

(19)

(11) **EP 1 248 367 A1**

(12) **EUROPEAN PATENT APPLICATION**

(43) Date of publication:
 **09.10.2002 Bulletin 2002/41**

(51) Int Cl.7: **H03H 11/48**

(21) Application number: **01400841.1**

(22) Date of filing: **03.04.2001**

(84) Designated Contracting States:
 **AT BE CH CY DE DK ES FI FR GB GR IE IT LI LU MC NL PT SE TR**
 Designated Extension States:
 **AL LT LV MK RO SI**

(71) Applicant: **ALCATEL**
 **75008 Paris (FR)**

(72) Inventors:
 • **Pollet, Thierry**
   **2800 Mechelen (BE)**
 • **Bloch, Stéphane**
   **1640 Rhode Saint Genese (BE)**

(74) Representative: **Plas, Axel et al**
 **Alcatel Bell N.V.,**
 **Francis Wellesplein 1**
 **2018 Antwerpen (BE)**

(54) **Active circuit simulating an inductance**

(57) The present invention is related to an apparatus comprising a tunable active circuit, said circuit synthe- sising a self-induction. The invention is characterised in that said active circuit comprises only one balanced/bal- anced Operational Amplifier.

FIG. 1

## Description

### Field of the invention

The present invention is related to active circuits, in particular active inductors, which are incorporated in integrated circuits.

### State of the art

Active inductors have been described, for example in document US-A-6028496, which is related to a device comprising two Operational Amplifiers (OPAMPS). The active inductor of this document includes an inverting amplifier of a common source (common emitter) type, which inversely amplifies an input signal and outputs the amplified signal as an output signal, a non-inverting amplifier of a common gate (common base) type, which non-inversely amplifies the output signal and the amplified signal as the input signal, a capacitor connected between the input signal and a reference signal, and a biasing portion for biasing the inverting amplifier and the non-inverting amplifier.

A general drawback of these existing active inductors is the fact that they all comprise at least two Operational Amplifiers, leading to a relatively high power consumption.

### Aims of the invention

The present invention aims to provide an active inductor which consumes less power compared to the active inductors belonging to the current state of the art.

### Summary of the invention

The present invention is related to an apparatus comprising an active circuit, said circuit synthesising an inductor, characterised in that said circuit comprises one Operational Amplifier.

According to a preferred embodiment, the invention is related to an apparatus comprising an active circuit, wherein said circuit comprises :

- an Operational Amplifier with a non-inverting input terminal, an inverting input terminal, a non-inverting output terminal and an inverting output terminal,
- a first resistor R1 and a first capacitance C1, connected in cascade between said inverting input terminal and a first output terminal of said active circuit,
- a second resistor R1', having the same resistance as R1, and a second capacitance C1', having the same capacitance value as C1, connected in cascade between said non-inverting input terminal and a second output terminal of said active circuit,
- a third resistor R2 and a fourth resistor R3, connected in cascade between said non-inverting input terminal and said first output terminal of said circuit,
- a fifth resistor R2', having the same resistance as R2, and a sixth resistor R3', having the same resistance as R3, said resistors R2' and R3' being connected in cascade between said inverting input terminal and said second output terminal of said circuit,
- a seventh resistor Rx and a third capacitance Cx, connected in parallel, and coupled between said inverting output terminal and a common node of said third resistor R2 and said fourth resistor R3,
- an eighth resistor Rx', having the same resistance as Rx, and a fourth capacitance Cx', having the same capacitance value as Cx, said resistor Rx' and said capacitance Cx' being connected in parallel, and coupled between said non-inverting output terminal and a common node of said fifth resistor R2' and said sixth resistor R3',
- a ninth resistor R4 connected between said inverting output terminal and said first output terminal of said circuit, and an tenth resistor R4', connected between said non-inverting output terminal and said second output terminal of said circuit.

According to the preferred embodiment of the present invention, the resistance values of R4 and R4' obey the following formula :

$$R4 = R4' = \frac{(C1.R1 + (2C1 - Cx).Rx).R3 + C1.R1.Rx}{Cx.Rx - C1.R1}$$

According to a further embodiment, the invention is related to an apparatus wherein the inductor synthesised by said active circuit is tuneable. This may be realised by making the capacitors C1, C1', Cx and Cx' tuneable.

According to another embodiment, the ratio between C1 and Cx is constant.

According to another embodiment, the value Rx.Cx is greater than R1.C1.

## Short description of the drawings

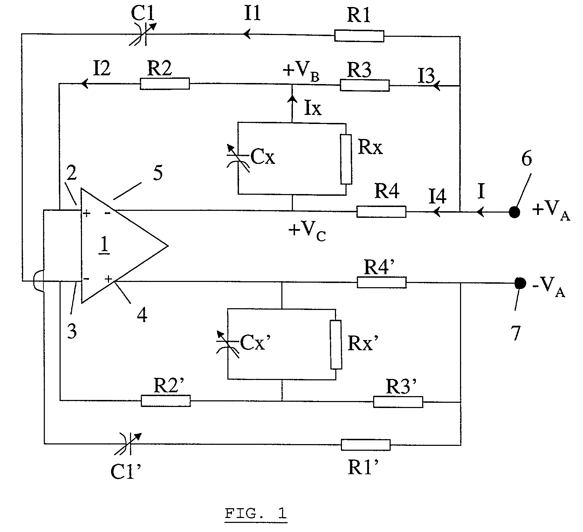

Fig. 1 represents the circuit of an active inductor according to the present invention.

## Detailed description of the invention

Referring to figure 1, the device according to a preferred embodiment of the invention is hereafter disclosed. The main characteristic of the invention is the fact that an active circuit is proposed, for synthesising an inductor, comprising only one Operational Amplifier.

The circuit can be made tuneable in order to select the self-inductance value. Figure 1 shows the embodiment wherein the circuit is tuneable, due to the presence of tuneable capacitors. An alternative would be the use of tuneable resistors or a combination of tuneable resistors and capacitors.

The operational amplifier 1 has non-inverting and inverting input terminals 2 and 3, and non-inverting and inverting output terminals 4 and 5.

The inverting input terminal 3 of the operational amplifier 1 is coupled via the cascade connection of a resistor R1 and a tuneable capacitance C1 to a first output terminal 6 of the circuit, and is coupled via the cascade connection of two resistors R2' and R3' to a second output terminal 7 of the circuit.

The non-inverting input terminal 2 of the operational amplifier 1 is coupled via the cascade connection of a resistor R1' and a tuneable capacitance C1' to the second output terminal 7 of the circuit, and is coupled via the cascade connection of two resistors R2 and R3 to the first output terminal 6 of the circuit.

The inverting output terminal 5 of the operational amplifier 1 is coupled via a resistor R4 to the first output terminal 6 of the circuit, and via the parallel connection of an tuneable capacitance Cx and a resistor Rx to the common node of the resistors R2 and R3.

The non-inverting output terminal 4 of the operational amplifier 1 is coupled via a resistor R4' to the second output terminal 7 of the circuit, and via the parallel connection of a tuneable capacitance Cx' and a resistor Rx' to the common node of the resistors R2' and R3'.

The following is true for the values of the above described resistors and capacitances :

R1=R1'; R2=R2'; R3=R3'; R4=R4'; Rx=Rx'; C1=C1'; Cx=Cx'

According to the invention, the resistor $R_4$ (and R4') is chosen such that:

$$R_4 = R_4' = \frac{(C_1.R_1 + (2C_1 - C_x).R_x).R_3 + C_1.R_1.R_x}{C_x.R_x - C_1.R_1}$$

As a result, the synthesised impedance behaves like the serial connection of a resistor and an inductor:

$$Z_{SYNTH} = R_{SYNTH} + i\omega L_{SYNTH}.$$

Herein:

$$R_{SYNTH} = \frac{2.R_3.R_4}{R_3 + R_4 + R_x} \text{ and}$$

$$L_{SYNTH} = \frac{2.R_3.R_4.R_x.C_x}{R_3 + R_4 + R_x} = R_{SYNTH}.R_x.C_x.$$

This is proven by the following mathematical derivation. The synthesized impedance is given by:

$$Z_{SYNTH} = \frac{V_A - (-V_A)}{1} = \frac{2V_A}{1} \tag{1}$$

with $V_A$ being the supply voltage.

The current I shown in figure 1, can be written as a function of currents $I_1$, $I_3$, and $I_4$ :

$$I = I_1 + I_3 + I_4 \tag{2}$$

$I_1$, $I_3$, and $I_4$ are determined below.

$I_1$ can be determined by expressing that the operational amplifier 1 is virtually grounded:

$$I_1 = \frac{V_A - 0}{Z_1} = \frac{V_A}{Z_1} \tag{3}$$

Herein,

$$Z_1 = R_1 + \frac{1}{i\omega C_1} \tag{4}$$

Furthermore,

$$I_3 = \frac{V_A - V_B}{R_3} \tag{5}$$

with

$$V_B = R_2 . I_2 \tag{6}$$

Kirchof's law applied at the non-inverting input 2 results in:

$$- I_1 + I_2 = 0 \Rightarrow I_2 = I_1 = \frac{V_A}{Z_1} \tag{7}$$

Substituting (7) in (6) results in:

$$V_B = V_A . \frac{R_2}{Z_1} \tag{8}$$

so that (5) turns into:

$$I_3 = V_A . \frac{1 - \frac{R_2}{Z_1}}{R_3} = V_A . \frac{Z_1 - R_2}{R_3 . Z_1} \tag{9}$$

From figure 1, one derives that:

$$I_4 = \frac{V_A - V_C}{R_4} \tag{10}$$

with

$$V_C = V_B + I_x . Z_x \tag{11}$$

Herein,

$$Z_x = R_x // C_x = \cfrac{1}{\cfrac{1}{R_x} + i\omega C_x} = \cfrac{R_x}{1 + i\omega R_x . C_x} \tag{12}$$

Kirchof's law applied in the $V_B$ node, results in:

$$I_3 + I_x - I_2 = 0 \Rightarrow I_x = I_2 - I_3 \tag{13}$$

After substitution of (7) and (9) in (13), one obtains:

$$I_x = \frac{V_a}{Z_1} - V_A . \frac{Z_1 - R_2}{R_3 . R_1} = V_A . \frac{R_2 + R_3 - Z_1}{R_3 . Z_1} \tag{14}$$

From equation (11), $V_C$ can now be derived:

$$
\begin{aligned}
V_C \quad &= V_A . \frac{R_2}{Z_1} + V_A . \frac{Z_x . (R_2 + R_3 - Z_1)}{R_3 . Z_1} \\
&= V_A . \frac{R_3 . R_2 + Z_x . (R_2 + R_3 - Z_1)}{R_3 . R_4 . Z_1}
\end{aligned}
\tag{15}
$$

(15) can be substituted in equation (10), resulting in:

$$I_4 = V_A . \frac{R_3 . Z_1 - R_3 . R_2 + Z_x . (Z_1 - R_2 - R_3)}{R_3 . R_4 . Z_1} \tag{16}$$

The expressions found in (3), (9) and (16) are to be substituted in (2) to find the current I:

$$
\begin{aligned}
I \quad &= I_1 + I_3 + I_4 \\
&= V_A . \frac{R_3 . R_4 - R_2 . R_4 + Z_1 . R_4 + R_3 . Z_1 - R_3 . R_2 + Z_x . (Z_1 - R_2 - R_3)}{R_3 . R_4 . Z_1}
\end{aligned}
$$

$$= V_A . \frac{(R_3 + R_4).(Z_1 - R_2) + \dfrac{R_3 . R_4}{R_3 + R_4} . (R_3 + R_4) + Z_x . (Z_1 - R_2 - R_3)}{R_3 . R_4 . Z_1} \tag{17}$$

Herein,

$$\frac{R_3.R_4}{R_3+R_4} = R_3//R_4 \tag{18}$$

and consequently:

$$I = V_A \cdot \frac{(R_3+R_4).(Z_1-R_2+R_3//R_4)+Z_x.(Z_1-R_2-R_3)}{R_3.R_4.Z_1} \tag{19}$$

$R_2$ is chosen as specified by (20)

$$R_2 = R_1 +R_3//R_4 \approx R_1 + R_3 \tag{20}$$

In order to fulfill the approximate equality, $R_3$ should preferably not be higher than 20% of $R_4$.
and by substituting (4) and (12) in (19), the expression for I becomes:

$$I = \frac{(R_3 + R_4 + R_x).\left(1+j\omega\dfrac{C_x.R_x.(R_3 + R_4) - 2.C_1.R_3.R_x}{R_3 + R_4 + R_x}\right)}{R_3.R_4.(1+j\omega C_1.R_1)(1+j\omega R_x.C_x)}.V_A \tag{21}$$

If $R_4$ is now chosen such that:

$$R_4 = \frac{(C_1.R_1+(2C_1-C_x).R_x).R_3+C_1.R_1.R_x}{C_x.R_x-C_1.R_1} \tag{22}$$

and (21) is substituted into (1), then the synthesized impedance behaves like the serial connection of a resistor and an inductor:

$$Z_{SYNTH} = R_{SYNTH} + i\omega L_{SYNTH} \tag{23}$$

with

$$R_{SYNTH} = \frac{2.R_3.R_4}{R_3+R_4+R_x} \tag{24}$$

and

$$L_{SYNTH} = \frac{2.R_3.R_4.R_x.C_x}{R_3+R_4+R_x} =R_{SYNTH}.R_x.C_x \tag{25}$$

The resistor $R_{SYNTH}$ can be made smaller than 1 $\Omega$ by choosing a high Rx, while the inductor can be a few µH. In order to keep R4 constant with C1 and Cx variable, a constant ratio should be chosen between C1 and Cx. Typically, Rx.Cx must be greater than R1.C1 in order to have a significantly high inductance with a small resistor value.
For example:
R1=R1'=500 $\Omega$        R3=R3'=10 $\Omega$        R2=R2'=510 $\Omega$        Rx=Rx'=1500 $\Omega$
R4=R4'=82 $\Omega$        RSYNTH=1.1 $\Omega$        Cx/C1=6
For LSYNTH=2 µH, we find Cx=1.21 nF

**Claims**

1. An apparatus comprising an active circuit (10), said circuit synthesising an inductor, **characterised in that** said circuit comprises one Operational Amplifier (1).

2. An apparatus according to claim 1, wherein said circuit comprises :

   - an Operational Amplifier (1) with a non-inverting input terminal (2), an inverting input terminal (3), a non-inverting output terminal (4) and an inverting output terminal (5),
   - a first resistor R1 and a first capacitance C1, connected in cascade between said inverting input terminal (3) and a first output terminal (6) of said active circuit (10),
   - a second resistor R1', having the same resistance as R1, and a second capacitance C1', having the same capacitance value as C1, connected in cascade between said non-inverting input terminal (2) and a second output terminal (7) of said active circuit (10),
   - a third resistor R2 and a fourth resistor R3, connected in cascade between said non-inverting input terminal (2) and said first output terminal (6) of said circuit,
   - a fifth resistor R2', having the same resistance as R2, and a sixth resistor R3', having the same resistance as R3, said resistors R2' and R3' being connected in cascade between said inverting input terminal (3) and said second output terminal (7) of said circuit,
   - a seventh resistor Rx and a third capacitance Cx, connected in parallel, and coupled between said inverting output terminal (5) and a common node of said third resistor R2 and said fourth resistor R3,
   - an eighth resistor Rx', having the same resistance as Rx, and a fourth capacitance Cx', having the same capacitance value as Cx, said resistor Rx' and said capacitance Cx' being connected in parallel, and coupled between said non-inverting output terminal (4) and a common node of said fifth resistor R2' and said sixth resistor R3',
   - a ninth resistor R4 connected between said inverting output terminal (5) and said first output terminal (6) of said circuit, and an tenth resistor R4', connected between said non-inverting output terminal (4) and said second output terminal (7) of said circuit.

3. An apparatus according to claim 2, wherein

$$R4 = R4' = \frac{(C1.R1 + (2C1 - Cx).Rx).R3 + C1.R1.Rx}{Cx.Rx - C1.R1}$$

4. An apparatus according to any one of claims 1 to 3, wherein the inductor synthesised by said active circuit is tuneable.

5. An apparatus according to claim 4, wherein said capacitors C1, C1', Cx and Cx' are tuneable.

6. An apparatus according to any one of the preceding claims, wherein the ratio between C1 and Cx is constant.

7. An apparatus according to any one of the preceding claims, wherein the value Rx.Cx is greater than R1.C1.

FIG. 1

European Patent Office

**EUROPEAN SEARCH REPORT**

Application Number

EP 01 40 0841

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 002, no. 099 (E-050), 17 August 1978 (1978-08-17) -& JP 53 065041 A (VICTOR CO OF JAPAN LTD), 10 June 1978 (1978-06-10) * abstract * | 1-7 | H03H11/48 |
| A | KEEN A W AND PETERS J L: "INDUCTANCE SIMULATION WITH A SINGLE DIFFERENTIAL-INPUT OPERATIONAL AMPLIFIER" ELECTRONICS LETTERS, vol. 3, no. 4, 1 April 1967 (1967-04-01), pages 136-137, XP002175043 * the whole document * | 1-7 | |

TECHNICAL FIELDS SEARCHED (Int.Cl.7)

H03H
H03J

The present search report has been drawn up for all claims

| Place of search | Date of completion of the search | Examiner |
|---|---|---|
| THE HAGUE | 16 August 2001 | Radomirescu, B-M |

EPO FORM 1503 03.82 (P04C01)

**ANNEX TO THE EUROPEAN SEARCH REPORT
ON EUROPEAN PATENT APPLICATION NO.**                    EP 01 40 0841

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2001

| Patent document cited in search report | Publication date | Patent family member(s) | Publication date |
|---|---|---|---|
| JP 53065041 A | 10-06-1978 | JP 1132841 C <br> JP 57024692 B | 27-01-1983 <br> 25-05-1982 |

EPO FORM P0459

For more details about this annex : see Official Journal of the European Patent Office, No. 12/82